# EUROPEAN PATENT SPECIFICATION

(11) **EP 3 919 650 B1**
(45) Date of publication and mention of the grant of the patent: **18.03.2026**
(21) Application number: 20178149.9
(22) Date of filing: 04.06.2020
(51) Int. Cl.: C23C 14/28, C23C 14/56

(54) **DEVICE FOR PULSED LASER DEPOSITION**
VORRICHTUNG ZUR GEPULSTEN LASERABSCHEIDUNG
DISPOSITIF DE DÉPÔT DE LASER PULSÉ

(43) Date of publication of application: 08.12.2021
(73) Proprietor: Lam Research Corporation, Fremont, CA 94538 (US)
(72) Inventor: Bohm, Kristiaan Hendrikus Aloysius, 7412 AD Deventer (NL); Hopman, Willem Cornelis Lambert, 7525 EH Deventer (NL); Dekkers, Jan Matthijn, 7611 CB Aadorp (NL); Janssens, Jan Arnaud, 7433 BJ Schalkhaar (NL); Berenbak, Bart, 1092 KZ Amsterdam (NL); te Boekhorst, Tom Bernard Henri, 7558 MR Hengelo (NL)
(74) Representative: Mewburn Ellis LLP

(56) References cited:
- EP-A1- 2 410 074
- EP-A1- 3 587 620
- EP-B1- 2 410 074
- JP-A- H03 199 370
- JP-A- H1 030 168
- JP-A- H1 030 169
- US-A1- 2007 089 385
- YOSHITAKE T ET AL: "Droplet-Free Thin Films Prepared by Pulsed Laser Deposition Using a Vane Velocity Filter", JAPANESE JOURNAL OF APPLIED PHYSICS, JAPAN SOCIETY OF APPLIED PHYSICS, JP, vol. 41, no. 2A PART.1, 1 February 2002 (2002-02-01), pages 836 - 837, XP002904273, ISSN: 0021-4922, DOI: 10.1143/JJAP.41.836

## Description

The invention relates to a device for pulsed laser deposition, a substrate with a substrate surface and a target with a target surface, which device comprises:
- a substrate holder for holding the substrate;
- a target holder for holding the target with the target surface facing the substrate surface;
- a velocity filter arranged between the substrate holder and the target holder, which velocity filter comprises a rotating, generally disc-shaped body with a rotation axis and with at least one filter passage opening extending from one axial surface to the other axial surface of the rotating body; and
- a pulsed laser directed onto the target at a target spot for generating a plasma plume of target material, wherein the surface of the target at the target spot faces the substrate surface,
wherein the path of the at least one filter passage opening coincides with the target spot when viewed in a direction perpendicular to the surface of the target at the target spot.

Such a device is for example known from EP 3587620. In this publication a velocity filter having a generally disc-shaped body is described, which filters away the particles, which are formed as an undesired by-product when generating the plasma plume from the target material. A plasma plate is furthermore provided between the velocity filter and the substrate to partially shape the plasma plume and any particles, which get past the velocity filter, by providing a shaped passage opening. The disadvantage is that part of the plasma plume is obstructed by the plasma plate and is deposited on the plasma plate around the edges of the shaped passage opening.

US 2007/089385 A1 discloses a deposition system having a rotary porous filter plate with multiple perforations which traps low-speed particles and droplets within the perforations while allowing high-speed fine particles to pass through for deposition onto a substrate.

It is an objective of the invention to reduce the above mentioned disadvantages.

This objective is achieved according to the invention with a device according to claim 1. Preferred embodiments are defined in the dependent claims.

When the pulsed laser hits the target, a plume will be generated comprising both a high velocity plasma as well as undesired particles, which have a substantially lower speed. By controlling the position and speed of the velocity filter, the filter passage opening can be positioned such, that the plasma plume will be ejected from the target surface through the filter passage opening onto the substrate surface. As the undesired particles are much slower, the filter passage opening will already have moved further, such that a substantial amount of the particles will be deposited on the rotating, disc-shaped body.

Particles which manage to enter the filter passage opening, will get in contact with the walls of the tapering opening and will be deposited at the walls of the passage opening. Due to the far higher velocity of the plasma, the plasma will be shaped by the tapering walls of the passage opening into a smaller and more condensed plume. A more condensed plasma plume enables a more accurate deposition on the substrate.

It is believed that the plasma will bounce off the tapering walls, while the undesired particles will get stuck to the tapering walls.

In the device according to the invention, relative to the rotation axis of the rotating body, the taper angle of the upstream wall part of the filter passage opening in rotation direction of the rotating body is smaller than the taper angle of the downstream wall part of the filter passage opening.

The rotating body spins at high velocity while the pulsed laser generates plasma plumes, which pass through the filter passage opening. Considering that the upstream wall part and downstream wall part have equal taper angles in stationary view, i.e. relative to the rotating body itself. Then due to the high velocity of the rotating body and accordingly of the filter passage opening, the upstream wall part will have a larger angle relative to the plasma plume which passes through the filter passage opening. Similarly, the downstream wall part will have a smaller angle relative to the plasma plume. So, in this preferred embodiment, the taper angle of the upstream wall part of the filter passage opening in rotation direction of the rotating body is smaller than the taper angle of the downstream wall part of the filter passage opening. This ensures that despite the high velocity of the rotating body and filter passage opening, the plasma plume will experience a filter passage opening with substantially equal taper angle for the upstream wall part and the downstream wall part.

Preferably, the taper angle of the upstream wall part is between 35° and 55°, is preferably 45°. Furthermore preferred, the taper angle of the downstream wall part is between the taper angle of the upstream wall part and 65°, preferably between 55° and 65°, and is more preferably 58,5°.

As both the downstream wall part and the upstream wall part form part of the filter passage opening, connecting wall parts will provide a transition from the different taper angles of the upstream and downstream wall parts.

In yet a further embodiment of the device according to the invention the length of the tapering, at least one filter passage opening is at least 20mm, preferably at least 32mm.

By providing the filter passage opening with a length of at least 20mm, preferably at least 32mm, it is ensured that virtually all undesired particles are caught by the velocity filter. Due to the length of the filter passage opening, the undesired particles cannot pass the passage opening without hitting at least one of the walls of the passage opening, such that the undesired particles are deposited on the wall of the filter passage opening.

In another preferred embodiment of the device according to the invention the filter passage opening has, when viewed in the direction of the rotation axis, a substantially rectangular cross-section. The rectangular cross-section shapes the plasma plume to have a more rectangular footprint, which is of advantage when the substrate is linearly moved relative to the plasma plume.

In yet another embodiment of the device according to the invention the at least one filter passage opening is provided as a channel along the circumferential wall of the rotating, generally disc-shaped body.

With the embodiment, wherein the filter passage opening is provided as a channel, the disc-shaped body can be more easily manufactured as common machining techniques can be used. The channel is closed by a housing wall in which the rotating body is arranged. The play between the housing wall and the rotating body is typically kept very small to prevent any undesired particles from going around the velocity filter and still deposit on the substrate.

In still a further embodiment of the device according to the invention, the rotating body is provided with at least two filter passage openings at the same radial distance from the rotation axis, wherein the at least two filter passage openings are evenly distributed along the circumference of the rotating body.

By providing two or more filter passage openings, the rotational speed of the rotating body can be divided by the number of openings. This allows for the timing of the filter passage openings to be more accurate and more easily to be controlled.

In still a further embodiment of the device according to the invention, for each at least one filter passage opening a laser passage opening is provided in the rotating body and wherein the laser passage opening is arranged on a radial line extending between the rotation axis and the corresponding filter passage opening.

These and other features of the invention will be elucidated in conjunction with the accompanying drawings.
Figure 1 shows a cross-sectional view in tangential direction of an embodiment of a device according to the invention.
Figure 2 shows a cross-sectional view in radial direction of the embodiment of figure 1.
Figure 3 shows a bottom view of the velocity filter seen from the target side.

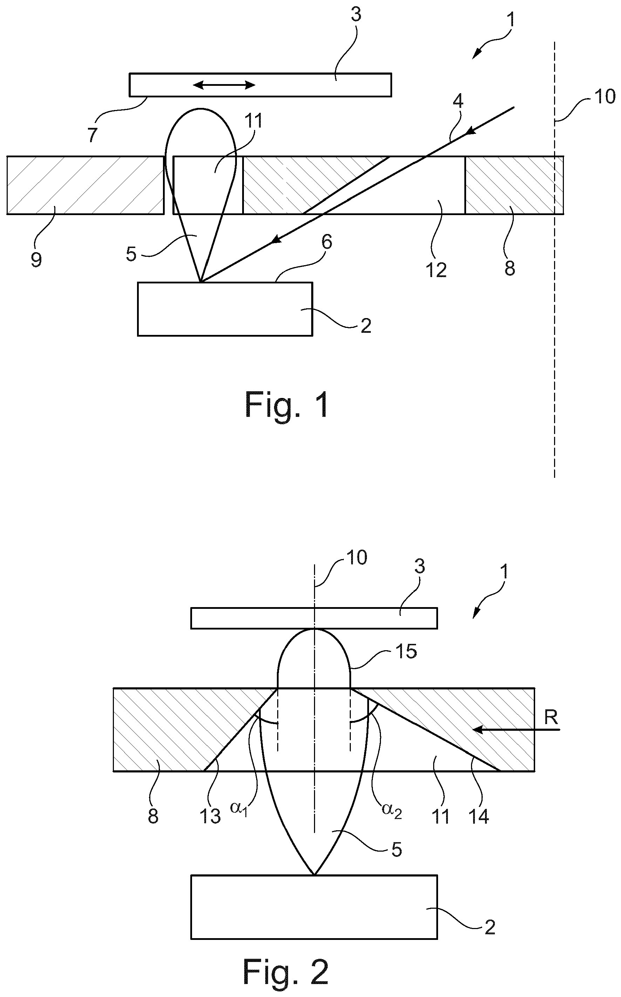

Figure 1 shows schematically an embodiment 1 of a device for pulsed laser deposition. The device 1 has a target 2, a substrate 3 and a pulsed laser beam 4. When the pulsed laser beam 4 hits the target surface 6, a plasma plume 5 is generated, which is deposited on the substrate surface 7. By moving the substrate 3, the full substrate surface 7 can be covered by deposited target material.

A velocity filter 8 is arranged between the substrate 3 and target 2. A housing part 9 is provided around the circumference of the rotating body 8, which rotates around the rotation axis 10. A filter passage opening 11 is provided in the rotating body 8 to let the plasma plume 5 pass towards the substrate 3, while slower and undesired particles are blocked by the rotating body 8.

A laser passage opening 12 is provided in the rotating body 8 to allow the laser beam 4 to pass the velocity filter. It is also possible to have the laser beam 4 coming from another direction, such that a laser passage opening 12 is not necessary. The laser passage opening 12 is arranged on a radial line extending between the rotation axis 10 and the corresponding filter passage opening 11.

Figure 2 shows the device 1 in radial direction. The filter passage opening 11 has, when considering the rotation direction R of the rotation body 8, an inclined upstream wall part 13 and an inclined downstream wall part 14, such that a tapering filter passage opening 11 is provided.

The upstream wall part 13 has, relative to the rotation axis 10 of the rotating body 8, a taper angle α₁ and the downstream wall part 14 has a taper angle α₂. The angle α₁ is smaller than the angle α₂ to compensate for the rotational speed of the rotating body 8 and accordingly the rotational speed of the filter passage opening 11.

As schematically shown, the plasma plume 5 is shaped by the tapering filter passage opening 11, such that the top 15 of the plasma plume 5 is more condensed and the substrate 3 can be covered more accurately with the target material.

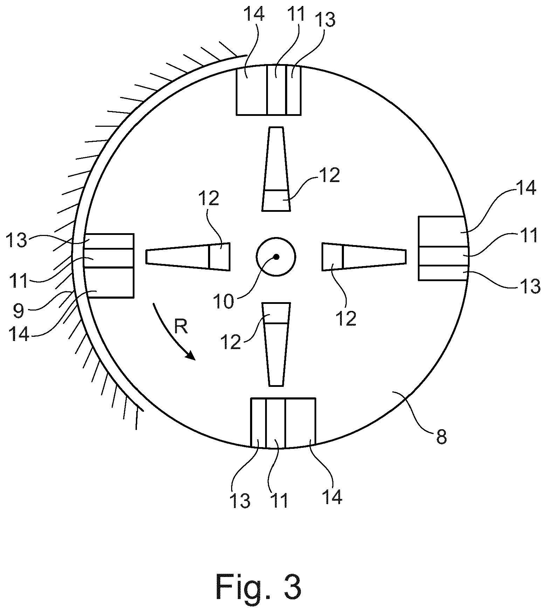

Figure 3 shows a bottom view of the velocity filter 8 seen from the target side 2. The rotating body 8 is provided with four identical filter passage openings 11, which have a rectangular cross-section and are each provided with the inclined, upstream wall part 13 and the inclined, downstream wall part 14, such that a tapering filter passage opening 11 is provided.

## Claims

1. Device (1) for pulsed laser deposition, a substrate (3) with a substrate surface (7) and a target (2) with a target surface (6), which device comprises:
- a substrate holder for holding the substrate (3);
- a target holder for holding the target (2) with the target surface (6) facing the substrate surface (7);
- a velocity filter (8) arranged between the substrate holder and the target holder, which velocity filter (8) comprises a rotating, generally disc-shaped body with a rotation axis (10) and with at least one filter passage opening (11) extending from one axial surface to the other axial surface of the rotating body; and
- a pulsed laser (4) directed onto the target (2) at a target spot for generating a plasma plume (5) of target material, wherein the surface (6) of the target (2) at the target spot faces the substrate surface (7),
wherein the path of the at least one filter passage opening (11) coincides with the target spot when viewed in a direction perpendicular to the surface (6) of the target at the target spot,
wherein the at least one filter passage opening (11) tapers from the target (2) to the substrate (3) in a direction parallel to the rotation axis (10) of the rotating body,
**characterized in that** relative to the rotation axis (10) of the rotating body, the taper angle (α₁) of the upstream wall part (13) of the filter passage opening (11) in rotation direction (R) of the rotating body is smaller than the taper angle (α₂) of the downstream wall part (14) of the filter passage opening (11).

2. Device (1) according to claim 1, wherein the taper angle (α₁) of the upstream wall part (13) is between 35° and 55°, is preferably 45°.

3. Device according to claim 1 or 2, wherein the taper angle (α₂) of the downstream wall part (14) is between the taper angle (α₁) of the upstream wall part (13) and 65°, preferably between 55° and 65°, and is more preferably 58,5°.

4. Device (1) according to any of the preceding claims, wherein the filter passage opening (11) has, when viewed in the direction of the rotation axis (10), a substantially rectangular cross-section.

5. Device (1) according to any of the preceding claims, wherein the rotating body is provided with at least two filter passage openings (11) at the same radial distance from the rotation axis (10), wherein the at least two filter passage openings (11) are evenly distributed along the circumference of the rotating body.

6. Device (1) according to any of the preceding claims, wherein for each at least one filter passage opening (11) a laser passage opening (12) is provided in the rotating body and wherein the laser passage opening (12) is arranged on a radial line extending between the rotation axis and the corresponding filter passage opening.

## Patentansprüche

1. Vorrichtung (1) für Laserpulsabscheidung, ein Substrat (3) mit einer Substratoberfläche (7) und ein Target (2) mit einer Target-Oberfläche (6), wobei die Vorrichtung Folgendes umfasst:
- eine Substrathalterung zum Halten des Substrats (3);
- eine Target-Halterung zum Halten des Targets (2), das mit der Target-Oberfläche (6) der Substratoberfläche (7) zugewandt ist;
- einen Geschwindigkeitsfilter (8), der zwischen der Substrathalterung und der Target-Halterung angeordnet ist, wobei der Geschwindigkeitsfilter (8) einen rotierenden, im Allgemeinen scheibenförmigen Körper mit einer Rotationsachse (10) und mit zumindest einer Filterdurchgangsöffnung (11), die sich von einer axialen Oberfläche zur anderen axialen Oberfläche des rotierenden Körpers erstreckt, umfasst; und
- einen gepulsten Laser (4), der an einem Target-Punkt auf das Target (2) gerichtet ist, um eine Plasmasäule (5) aus Target-Material zu erzeugen, wobei die Oberfläche (6) des Targets (2) am Target-Punkt der Substratoberfläche (7) zugewandt ist,
wobei der Pfad der zumindest einen Filterdurchgangsöffnung (11) in eine Richtung orthogonal zur Oberfläche (6) des Targets am Target-Punkt mit dem Target-Punkt zusammenfällt,
wobei sich die zumindest eine Filterdurchgangsöffnung (11) vom Target (2) zum Substrat (3) in eine Richtung parallel zur Rotationsachse (10) des rotierenden Körpers verjüngt,
**dadurch gekennzeichnet, dass** der Verjüngungswinkel (α₁) des Stromauf-Wandteils (13) der Filterdurchgangsöffnung (11) in Rotationsrichtung (R) des rotierenden Körpers bezogen auf die Rotationsachse (10) des rotierenden Körpers kleiner ist als der Verjüngungswinkel (α₂) des Stromab-Wandteils (14) der Filterdurchgangsöffnung (11).

2. Vorrichtung (1) nach Anspruch 1, wobei der Verjüngungswinkel (α₁) des Stromauf-Wandteils (13) zwischen 35° und 55° ist, vorzugsweise 45° ist.

3. Vorrichtung nach Anspruch 1 oder 2, wobei der Verjüngungswinkel (α₂) des Stromab-Wandteils (14) zwischen dem Verjüngungswinkel (α₁) des Stromauf-Wandteils (13) und 65° liegt, vorzugsweise zwischen 55° und 65°, noch bevorzugter 58,5° ist.

4. Vorrichtung (1) nach einem der vorangegangenen Ansprüche, wobei die Filterdurchgangsöffnung (11) in die Richtung der Rotationsachse (10) gesehen einen im Wesentlichen rechteckigen Querschnitt aufweist.

5. Vorrichtung (1) nach einem der vorangegangenen Ansprüche, wobei der rotierende Körper mit zumindest zwei Filterdurchgangsöffnungen (11) im gleichen radialen Abstand von der Rotationsachse (10) versehen ist, wobei die zumindest zwei Filterdurchgangsöffnungen (11) gleichmäßig entlang des Umfangs des rotierenden Körpers verteilt sind.

6. Vorrichtung (1) nach einem der vorangegangenen Ansprüche, wobei für jede zumindest eine Filterdurchgangsöffnung (11) eine Filterdurchgangsöffnung (12) im rotierenden Körper bereitgestellt ist und wobei die Filterdurchgangsöffnung (12) auf einer radialen Linie angeordnet ist, die sich zwischen der Rotationsachse und der entsprechenden Filterdurchgangsöffnung erstreckt.

## Revendications

1. Dispositif (1) pour un dépôt par laser pulsé d'un substrat (3) avec une surface de substrat (7) et d'une cible (2) avec une surface de cible (6), lequel dispositif comprend :
- un dispositif de maintien de substrat pour maintenir le substrat (3) ;
- un dispositif de maintien de cible pour maintenir la cible (2) avec la surface de cible (6) faisant face à la surface de substrat (7) ;
- un filtre de vitesse (8) agencé entre le dispositif de maintien de substrat et le dispositif de maintien de cible, lequel filtre de vitesse (8) comprend un corps rotatif généralement en forme de disque avec un axe de rotation (10) et avec au moins une ouverture de passage de filtre (11) s'étendant d'une certaine surface axiale à l'autre surface axiale du corps rotatif ; et
- un laser pulsé (4) dirigé sur la cible (2) au niveau d'un point cible pour générer un panache de plasma (5) de matériau cible, dans lequel la surface (6) de la cible (2) au niveau du point cible fait face à la surface de substrat (7),
dans lequel le trajet de la au moins une ouverture de passage de filtre (11) coïncide avec le point cible lorsqu'il est vu dans une direction perpendiculaire à la surface (6) de la cible au niveau du point cible,
dans lequel la au moins une ouverture de passage de filtre (11) est conique depuis la cible (2) vers le substrat (3) dans une direction parallèle à l'axe de rotation (10) du corps rotatif,
**caractérisé en ce que**, par rapport à l'axe de rotation (10) du corps rotatif, l'angle de conicité (α₁) de la partie de paroi amont (13) de l'ouverture de passage de filtre (11) dans la direction de rotation (R) du corps rotatif est inférieur à l'angle de conicité (α₂) de la partie de paroi aval (14) de l'ouverture de passage de filtre (11).

2. Dispositif (1) selon la revendication 1, dans lequel l'angle de conicité (α₁) de la partie de paroi amont (13) est compris entre 35° et 55°, et est de préférence de 45°.

3. Dispositif selon la revendication 1 ou 2, dans lequel l'angle de conicité (α₂) de la partie de paroi aval (14) est compris entre l'angle de conicité (α₁) de la partie de paroi amont (13) et 65°, de préférence entre 55° et 65°, et est plus préférablement de 58,5°.

4. Dispositif (1) selon l'une quelconque des revendications précédentes, dans lequel l'ouverture de passage de filtre (11) présente, lorsqu'elle est vue dans la direction de l'axe de rotation (10), une section transversale sensiblement rectangulaire.

5. Dispositif (1) selon l'une quelconque des revendications précédentes, dans lequel le corps rotatif est pourvu d'au moins deux ouvertures de passage de filtre (11) à la même distance radiale de l'axe de rotation (10), dans lequel les au moins deux ouvertures de passage de filtre (11) sont réparties de manière régulière le long de la circonférence du corps rotatif.

6. Dispositif (1) selon l'une quelconque des revendications précédentes, dans lequel pour chaque au moins une ouverture de passage de filtre (11), une ouverture de passage de laser (12) est prévue dans le corps rotatif, et dans lequel l'ouverture de passage de laser (12) est agencée sur une ligne radiale s'étendant entre l'axe de rotation et l'ouverture de passage de filtre correspondante.
